# EUROPEAN PATENT SPECIFICATION

(11) **EP 0 245 515 B1**
(45) Date of publication and mention of the grant of the patent: **16.04.1997**
(21) Application number: 86906927.8
(22) Date of filing: 12.11.1986
(51) Int. Cl.: H01L 27/06, H01L 27/08, H01L 29/78

(54) **SEMICONDUCTOR DEVICE**
HALBLEITERANORDNUNG
DISPOSITIF A SEMI-CONDUCTEURS

(30) Priority: 20.11.1985 JP 258506/85
(43) Date of publication of application: 19.11.1987
(73) Proprietor: HITACHI, LTD., Chiyoda-ku, Tokyo 101 (JP)
(72) Inventor: KITSUKAWA, Goro, Hinodecho, Nishitama-gun Tokyo 190-01 (JP); ITOH, Kiyoo, Higashikurume-shi Tokyo 203 (JP); HORI, Ryoichi, Hinodecho, Nishitama-gun Tokyo 190-01 (JP); WATANABE, Takao, Kokubunji-shi Tokyo 185 (JP); SHIMOHIGASHI, Katsuhiro, Musashimurayama-shi Tokyo 190-12 (JP); HOMMA, Noriyuki, Kodaira-shi Tokyo 187 (JP)
(74) Representative: Strehl Schübel-Hopf Groening & Partner
(86) International application number: JP8600579
(87) International publication number: WO8703423

(56) References cited:
- JP-A- 0 567 463
- JP-A-49 128 684
- JP-A-59 143 359
- JP-A-59 144 168
- US-A- 4 497 043
- PATENT ABSTRACTS OF JAPAN, vol. 8, no. 107 (E-245)[1544], 19th May 1984; & JP-A-59 22 359 (NIPPON DENKI K.K.) 04-02-1984
- IEEE TRANSACTIONS ON ELECTRON DEVICES, vol. ED-31, no. 1, January 1984, pages 89-95, IEEE, New York, US; S. KRISHNA et al.: "An analog technology integrates bipolar, CMOS, and high-voltage DMOS transistors"
- IBM TECHNICAL DISCLOSURE BULLETIN, vol. 16, no. 8, January 1974, pages 2701- 2703, New York, US; I. ANTIPOV: "Forming complementary field-effect devices and NPN transistors"

## Description

### Technical Field:

The present invention relates to a method of isolation among devices within a semiconductor device.

### Background Art:

Heretofore, in an integrated circuit employing insulated-gate field effect transistors (hereinafter, abbreviated to 'MOS transistors') or bipolar transistors (hereinafter, abbreviated to 'BIP transistors'), the isolation among the devices has been performed by applying reverse bias voltages to p-n junctions. The details are stated in, for example, "Integrated Circuit Technology (1)" (Corona Publishing Co., Ltd.) by Yanai and Nagata, p. 21 - p. 31.

Further from US-PS 4,497,043 a semiconductor memory device is known, wherein a first substrate region of a first conductivity type including a memory section constituted by a first MOS transistor is surrounded by a second substrate region of the second conductivity type including a second MOS transistor. A reversed bias voltage can be applied at the p-n junction between said first and second substrate regions to isolate said transistors.

On the other hand, in a logic LSI or SRAM (static RAM), attention has been riveted in recent years to the so-called BiCMOS system wherein a bipolar transistor and a CMOS transistor device (a complementary MOS transistor device composed of both n-channel and p-channel MOS transistors) are combined to exploit the features of the high speed of the former and the high density and low power dissipation of the latter, thereby to realize a logic LSI or SRAM of high speed, high density and low power dissipation. It is stated in detail in "Nikkei Electronics," August 12, 1985, p. 187 - p. 208, etc. Also in such a BiCMOS system, a device isolation method similar to the above is adopted.

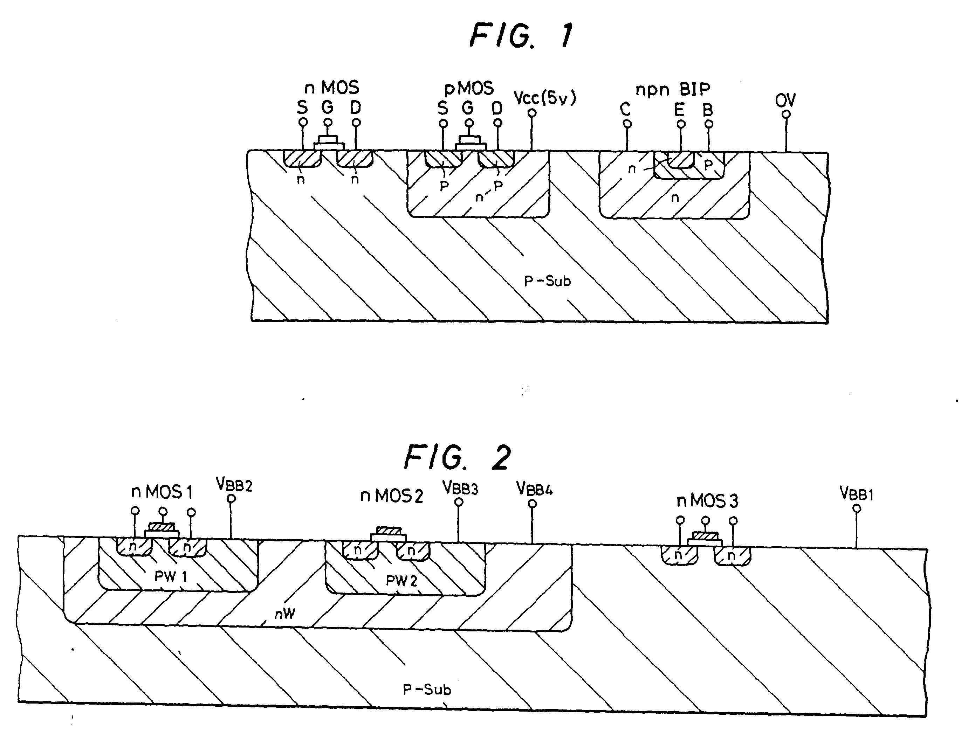

Fig. 1 illustrates the fundamental sectional structure of the BiCMOS system. Shown in the figure are one n-channel MOS (nMOS) transistor, as well as one p-channel MOS (pMOS) transistor, and an n-p-n bipolar (npnBIP) transistor.

Here, letters S, G and D affixed to the nMOS or pMOS indicate the nodes of the source, gate and drain thereof, respectively, while letters C, E and B affixed to the npnBIP transistor indicate the nodes of the collector, emitter and base thereof, respectively (in the following drawings, these node names shall be omitted). Besides, in the figure, diffusion layers have only the impurity types thereof written down for the sake of brevity. Accordingly, as regards portions to which the same symbols are assigned, it is merely indicated that the conductivity types are the same, and the impurity materials and impurity concentrations are selected at will properly according to the purposes of the portions. Unless particularly specified, these facts hold true also in the ensuing drawings. In such a structure, with the prior art, the isolation among a large number of devices within a chip is executed by applying the lowest potential in the circuitry to a p-type substrate (p-Sub) and the highest potential in the circuitry to the n-type isolation layer (nWELL) for forming the pMOS transistor, whereby the junctions of various parts are prevented from falling into the condition of forward bias. That is, with the prior art, in a case where the circuitry operates between a supply voltage (for example, 5 V) and the earth (0 V), the devices are isolated by applying 0 V to the substrate p-Sub and 5 V to the n-type isolation layer. Since, in such a system, the applied voltage to the substrate p-Sub or to the n-type isolation layer is selected at the lowest voltage required for the device isolation, reverse bias voltages to be applied to the p-n junctions can be rendered small, and therefore it is possible to cope with the problems of lowering in the breakdown voltages of devices, etc. attendant upon the future microminiaturization of the devices. On the other hand, however, a problem to be stated below arises.

Since the input or output terminal of the LSI is directly connected with an external circuit, noise above the supply voltage or below 0 V (in general, surge noise such as overshoot or undershoot) might arrive. Since the input or output node is connected to the diffusion layer within the chip in any form, the corresponding junction will then be forward-biased in the prior art. By way of example, when the minus surge noise is applied to the n-type diffusion layer indicated at the source S or drain D of the nMOS transistor in Fig. 1, the junction between the n-type diffusion layer and the substrate p-Sub is forward-biased, and a forward current flows from the substrate p-Sub toward the n-type diffusion layer. As a result, minority carriers (electrons in a p-type substrate) are injected into the substrate p-Sub. Since the minority carriers have a mean free path which is usually as long as several hundred µm, they reach another circuit part and incur, for example, the problem that a stored signal in a memory cell is destroyed in an SRAM or DRAM. The phenomenon of the minority carrier injection might be caused, not only at the input or output node part, but also by a circuit operation inside the chip in such a manner that the potential of the diffusion layer or of the substrate p-Sub fluctuates locally due to capacitive coupling or due to saturated operation of the bipolar transistor. It is therefore impossible to realize high performance of the BiCMOS system.

### Disclosure of the Invention:

The object of the present invention is to solve the problem described above, and to provide a semiconductor device which operates stably, wherein a voltage to be applied to the substrate or an isolation region can be freely set according to an intended use.

This object is met by the semiconductor devices defined in claims 1 and 4, with preferred embodiments set forth in the further claims.

In the present invention, a voltage which is still negative (in general, when a p-type silicon substrate is used) or positive (in general, when an n-type silicon substrate is used) with respect to the operating voltage of circuitry is applied to a portion liable to the injection of minority carriers, for example, a substrate.

Further, in the present invention, in order to solve problems ascribable to the method of applying the voltage as stated above, for example, the problem that voltages to be applied to individual devices increase to degrade the reliability of a device of low breakdown voltage such as a microminiature device, the isolation region of MOS transistors of identical conductivity type or bipolar transistors of identical conductivity type is divided into several isolated regions, to which suitable isolation voltages are applied according to the respective uses.

### Brief Description of the Drawings:

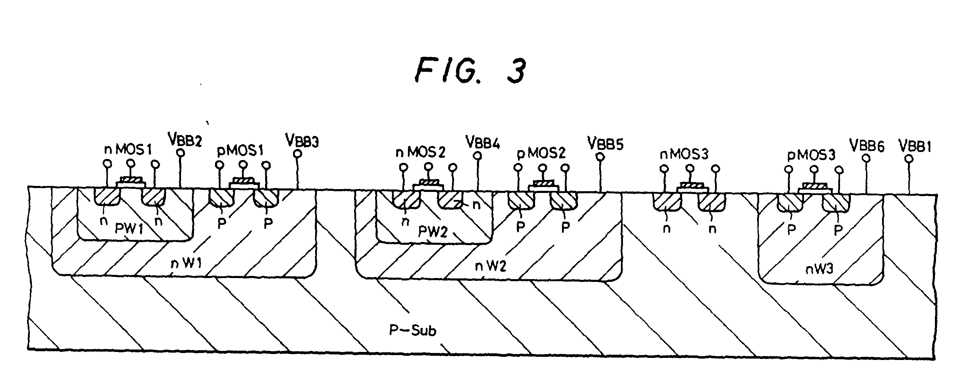

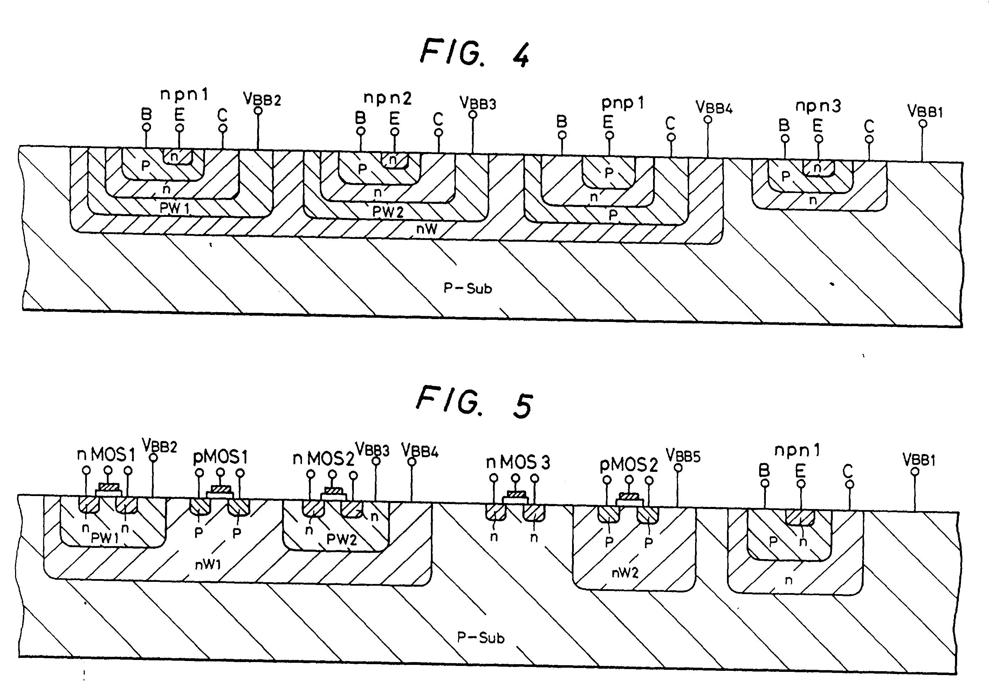

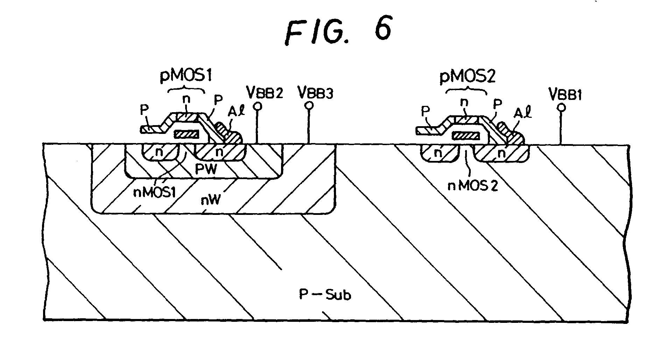

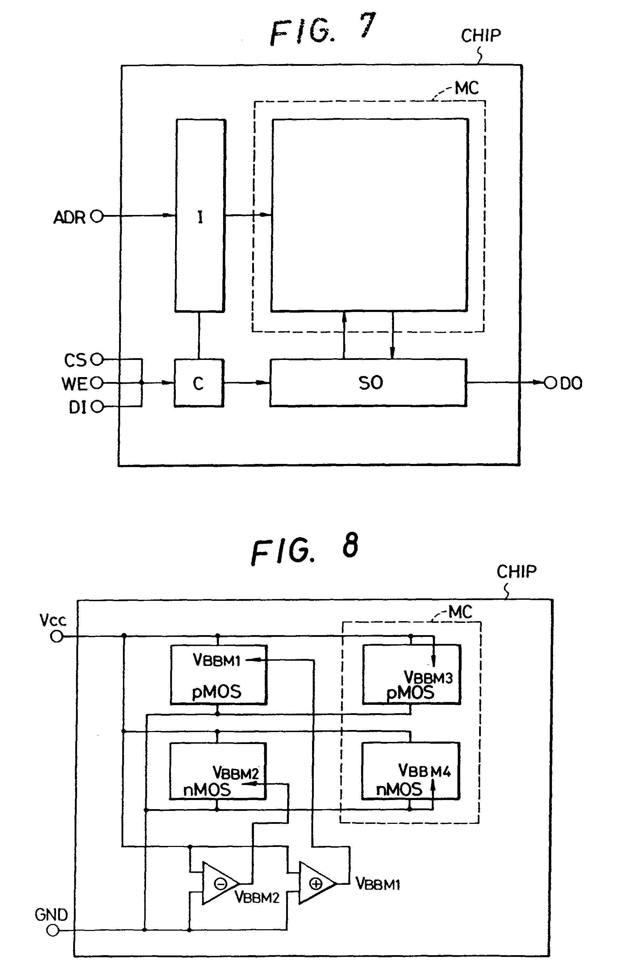

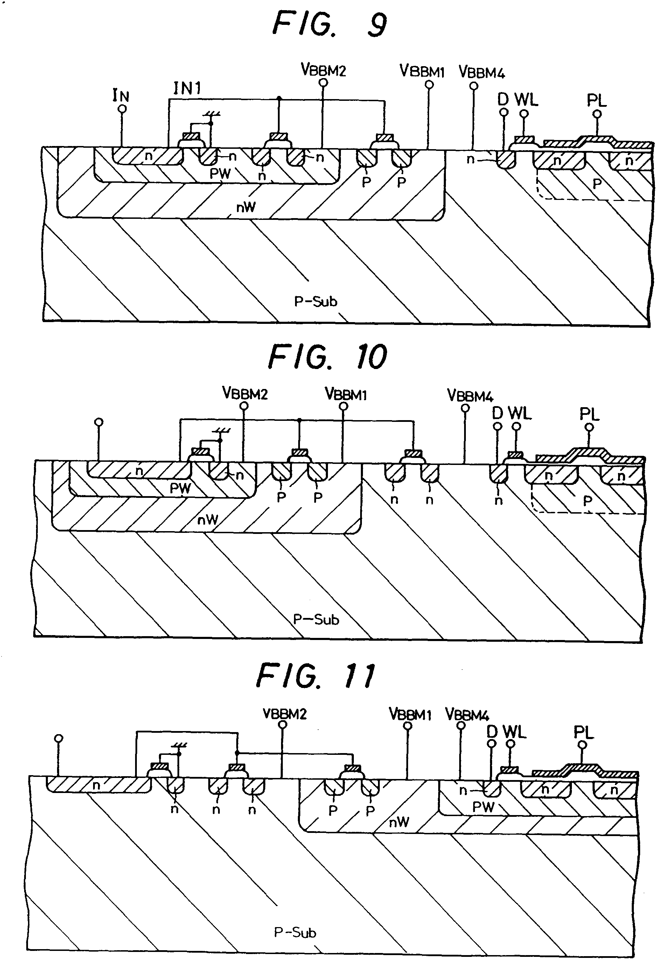

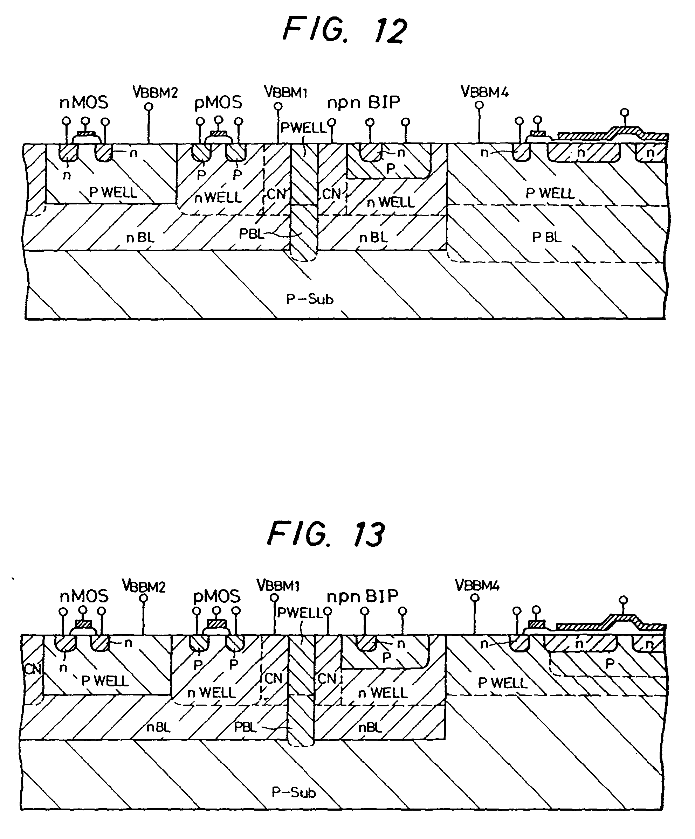

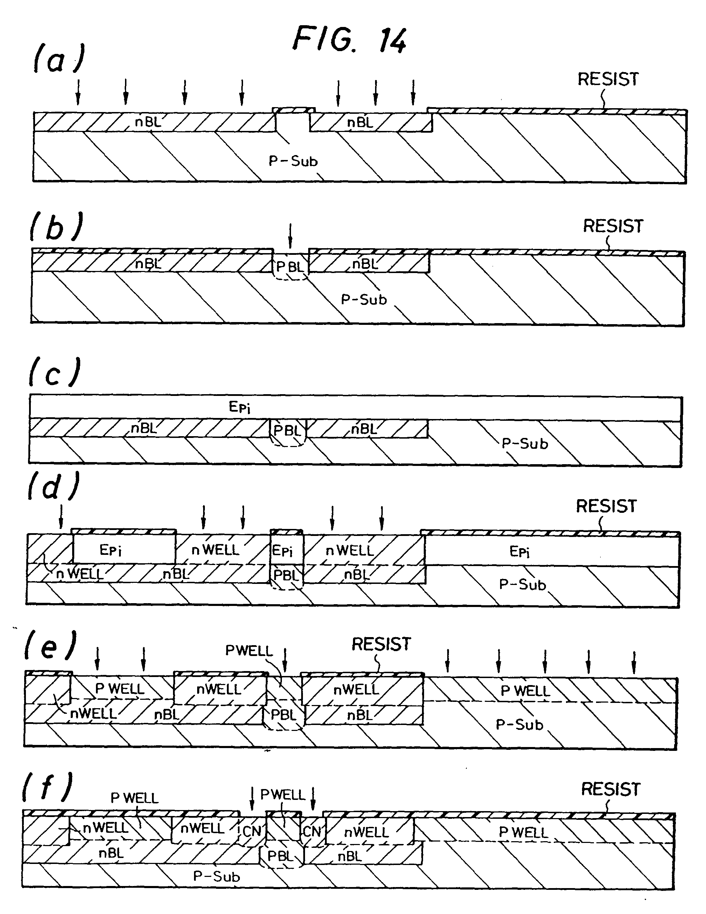

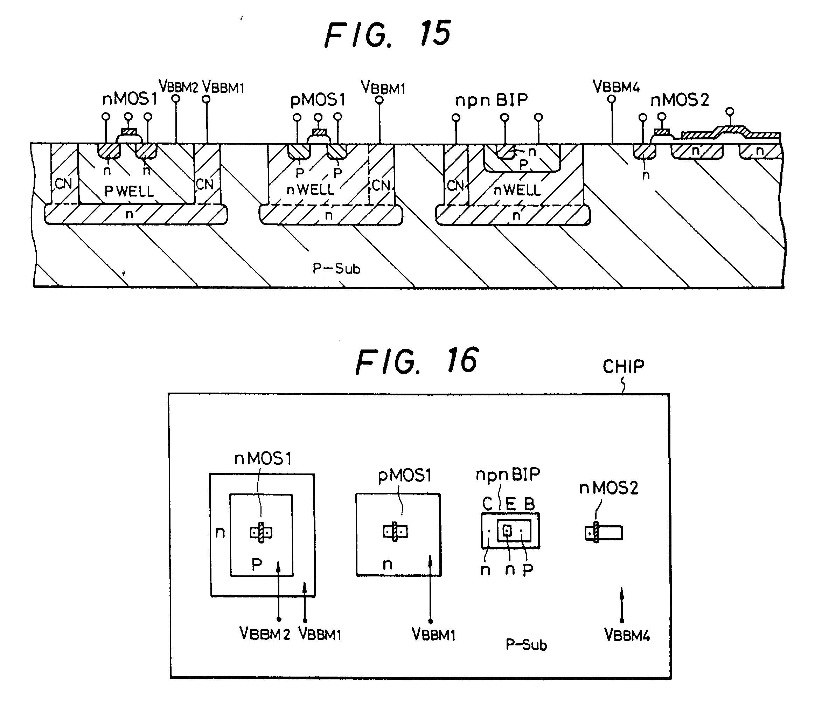

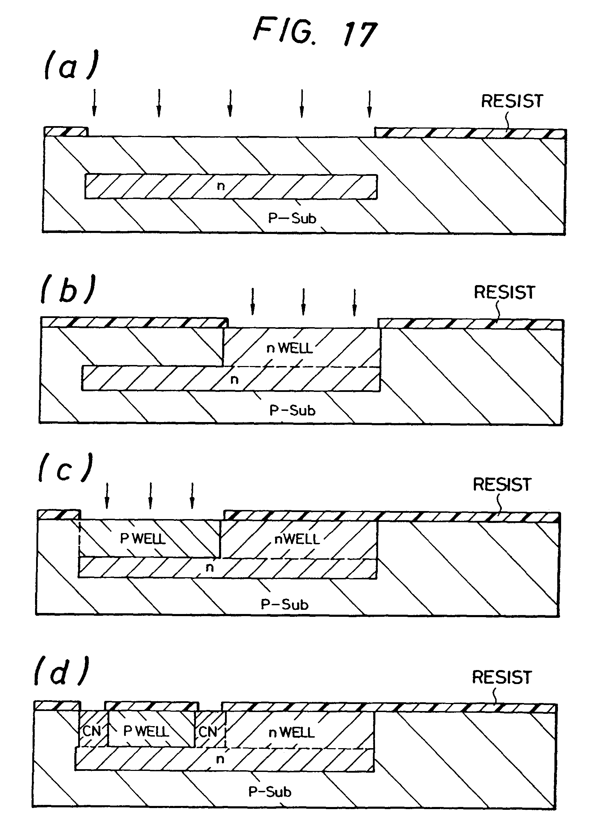

Fig. 1 is a sectional view showing a prior art, Fig. 2 is a sectional view showing an embodiment of the present invention, Fig. 3 is a sectional view showing an embodiment of a CMOS structure, Fig. 4 is a sectional view showing an embodiment of a bipolar structure, Fig. 5 is a sectional view showing an embodiment of a bipolar-CMOS complex structure, Fig. 6 is a sectional view showing an embodiment of an SOI structure, Fig. 7 is a block diagram of a memory, Fig. 8 is a diagram showing an embodiment for the application of a substrate isolation voltage to a memory, Figs. 9 - 11 are sectional views each showing an embodiment of a MOS dynamic memory, Figs. 12 and 13 are sectional views each showing an embodiment of a bipolar-CMOS complex dynamic memory, Fig. 14 illustrates sectional views showing an embodiment of principal steps for realizing the structure in Fig. 13, Fig. 15 is a sectional view showing another embodiment of the bipolar-CMOS complex dynamic memory, Fig. 16 is a plan view with the embodiment of Fig. 15 seen from the front surface of a chip, and Fig. 17 illustrates sectional views showing an embodiment of principal steps for realizing the structure in Fig. 16.

### Best Mode for Carrying Out the Invention:

Now, the details of the present invention will be described in conjunction with embodiments.

Fig. 2 illustrates an integrated circuit of nMOS transistors. A construction in the figure is such that a p-type substrate (p-Sub) is formed therein with an n-well layer NW, in which p-well layers PW₁ and PW₂ are further formed. The nMOS transistors formed in the two p-wells and the substrate p-Sub are respectively denoted by symbols nMOS1, nMOS2 and nMOS3. In this structure, voltages V_{BB1}, V_{BB2} and V_{BB3} independent of one another can be applied to the isolation layers of the three sorts of nMOS transistors, and they can be selected at suitable voltages according to circuit uses.

On the other hand, the supply voltage V_{CC} or a voltage which is at least higher than both the voltages V_{BB2} and V_{BB3} is applied as V_{BB4} to the n-well layer NW. Although the single nMOS transistor has been shown in Fig. 2, one well usually has a plurality of nMOS transistors in each of three isolation layers.

In addition, although the two p-wells and the single n-well have been shown in Fig. 2, this embodiment is also applicable to a combination wherein a plurality of n-wells are provided and wherein one or more p-wells are designed in each of the n-wells. Further, the present invention can be readily applied to a pMOS integrated circuit merely by altering the conductivity types of the substrate, wells and MOS transistors and reversing all the potential relations. The voltage V_{BB1} may be applied to the substrate either from the front surface or from the rear surface thereof.

Fig. 3 illustrates an embodiment in which the present invention is applied to a CMOS (complementary MOS) structure. Referring to the figure, three n-wells (NW₁, NW₂, NW₃) are formed in a p-type substrate, and p-wells (PW₁, PW₂) are further formed in the respective n-wells NW₁ and NW₂. Thereafter, nMOS transistors (nMOS1, nMOS2, nMOS3) are respectively formed in the p-wells (PW₁, PW₂) and the substrate p-Sub. Besides, pMOS transistors (pMOS1, pMOS2, pMOS3) are respectively formed in the n-wells (NW₁, NW₂, NW₃). In this construction, voltages V_{BB2}, V_{BB4} and V_{BB1} are applied to the p-type isolation layers for the nMOS transistors. On the other hand, voltages V_{BB3}, V_{BB5} and V_{BB6} are applied to the n-type isolation layers for the pMOS transistors. As three voltages V_{BB2}, V_{BB4} and V_{BB1} or as three voltages V_{BB3}, V_{BB5} and V_{BB6}, voltages of at least two values unequal to each other are applied according to circuits used. By way of example, voltages of GND (0 V) and -3 V are applied as the voltages V_{BB2}, V_{BB4} and V_{BB1}, while voltages of V_{CC} (+5 V) and V_{CC} + α (+7 V) are applied as the voltages V_{BB3}, V_{BB5} and V_{BB6}. In this way, the voltages as desired can be applied to the individual isolation layers of the nMOS and pMOS transistors. Although, in Fig. 3, only one MOS transistor has been shown in each of the wells, a plurality of MOS transistors may well be provided as are necessary. In addition, although the numbers of the wells are 3 as the n-wells and 2 as the p-wells in Fig. 3, they may be increased or decreased as are necessary. Further, it is to be understood that the present invention is also applicable to a construction wherein the polarities of the substrate and the wells are inverted. That is to say, p-wells are first formed in an n-type substrate and wherein n-wells are subsequently formed.

While the embodiments described above concern the construction employing only the MOS transistors, there will now be described examples in each of which the present invention is applied to an integrated circuit employing bipolar transistors or an integrated circuit having both bipolar and MOS transistors.

Fig. 4 illustrates an embodiment in which the present invention is applied to an integrated circuit employing bipolar transistors. Referring to Fig. 4, three n-p-n bipolar transistors (npnl, npn2, npn3) are one p-n-p bipolar transistor (pnp1) are formed. In a conventional bipolar integrated circuit, a plurality of n-p-n transistors are constructed in a p-type substrate p-Sub likewise to the transistor npn3 in this figure and are fed with a common substrate voltage as a voltage V_{BB1} from the front surface or rear surface of a chip. When the magnitude of the voltage V_{BB1} is set at the lowest potential GND (0 V) in circuitry or at a still lower potential, the plurality of bipolar transistors can be isolated from one another. In the present invention, p-type isolation layers separated from the substrate p-Sub are further provided as indicated by symbols PW₁ and PW₂, and the n-p-n transistors (npnl, npn2) are formed therein. The p-layers have voltages V_{BB2} and V_{BB3} applied thereto. The values of the voltages V_{BB2} and V_{BB3} can be set independently of the voltage V_{BB1}. A voltage V_{BB4} is applied to an n-type layer (nW) for isolating the substrate p-Sub and the p-layers. When a voltage V_{BB4} (for example, equal to the supply voltage V_{CC}) is higher than the three voltages V_{BB1}, V_{BB2} and V_{BB3}, the transistors npn1, npn2 and npn3 can be perfectly isolated from one another. The p-n-p transistor (pnp1) in the figure can be constructed by employing some of layers used for forming the transistors npnl and npn2. When the conductivity types of all the layers including the substrate are reversed, unequal voltages can be applied to n-type isolation layers forming a plurality of p-n-p transistors.

Next, there will be elucidated an example in which the present invention is applied to the so-called BiCMOS structure having both CMOS and bipolar transistors in a chip. Fig. 5 illustrates the embodiment in which nMOS transistors (nMOS1, nMOS2, nMOS3) and pMOS transistors (pMOS1, pMOS2) are formed in a p-type substrate p-Sub as in Fig. 3, and in which an n-p-n bipolar transistor (npnl) is further formed. As in the foregoing, voltages VBB₁, V_{BB2} and V_{BB3} can be independently set as the isolation voltages of the nMOS transistors. In addition, voltages V_{BB4} and V_{BB5} can be independently set as the isolation voltages of the pMOS transistors. The substrate voltage V_{BB1} of the transistor nMOS3 is applied to the isolation region of the bipolar transistor, but this voltage V_{BB1} can be set as an isolation voltage dedicated to the bipolar transistor in the absence of the transistor nMOS3. In addition, when a structure similar to that of the transistor npnl in Fig. 4 is incorporated in the construction of Fig. 5, isolation voltages unequal to each other can be fed to the bipolar transistors. Besides, a p-n-p transistor can be formed as in Fig. 4. Also, when the conductivity types of the substrate, the wells, the sources and drains of the MOS transistors, and the collector, emitter and base of the bipolar transistor are all inverted, a p-n-p transistor and a CMOS structure can be constructed, and the plurality of isolation voltages of the present invention can be applied to such a construction.

Fig. 6 shows an embodiment in which the present invention is applied to the nMOS portion of a stacked 'CMOS structure. The figure shows the example which is formed with nMOS transistors on the side of a substrate, and with pMOS transistors on the substrate by the so-called SOI structure wherein polycrystalline Si is grown on an insulator film. By combining such a configuration with a p-well (pW) and an n-well (nW), independent voltages V_{BB2} and V_{BB1} can be applied to the respective isolation portions of the transistor nMOS1 formed in the p-well and the transistor nMOS2 formed in the substrate p-Sub. In addition, when the conductivity types of the substrate and the wells are rendered opposite, it is possible to form pMOS transistors on the substrate side and nMOS transistors on the polycrystalline Si side and to apply separate isolation voltages to the isolation portions of the pMOS transistors.

Now, there will be described embodiments in which these structures are applied to semiconductor memories.

Fig. 7 is a block diagram of any of general memories (including a dynamic RAM, a static RAM, a ROM, etc.). Symbol ADR denotes an address input, symbol CS a chip select input, symbol WE a write enable input, symbol DI a data input, and symbol DO a data output. The designations of these signals are mere examples, and other designations are sometimes used.

A block I indicates an addressbuffer as well as a decoder and a driver. A block C indicates a control circuit and a write circuit. A block MC indicates a memory cell array. A block SO indicates a sense circuit and an output circuit. One embodiment of the present invention consists is applying the different voltage to the memory all array MC enclosed with a broken line from to the other portion.

Referring to Fig. 8, a chip which includes the two blocks isolated as in Fig. 7 has a built-in substrate bias voltage generator, and the two outputs V_{BBM1} and V_{BBM2} of the bias voltage generator are applied to the peripheral circuits other than the memory cell array, while a supply voltage V_{CC} and the ground potential GND are applied to the memory cell array as V_{BBM3} and V_{BBM4} respectively. The circuit arrangement of the substrate bias voltage generator has already been disclosed in "1976 ISSCC," pp. 138 - 139 or Japanese Patent Application Laid-open No. 51-117584. In this construction, by way of example, the isolation region (n-well) of the pMOS transistor of the peripheral circuit is fed with the voltage V_{BBM1} (+7 V) and the isolation region (p-well) of the nMOS transistor thereof with the voltage V_{BBM2} (-3 V), while the n-well of the pMOS transistor of the cell array is fed with the voltage V_{CC} and the p-well of the nMOS transistor thereof with 0 V. By supplying the voltage of large absolute values to the isolation regions of the input and output circuits in this manner, the memory becomes stable against the overshoots and undershoots of input and output signals, junction capacitances (the capacitances between the sources or drains of MOS transistors and a substrate,and the capacitances between the collectors of bipolar transistors and the substrate) can be reduced, and an impurity concentration profile less prone to soft errors can be selected for the cell array. By the way, the designations of isolation voltages for use in the following embodiments shall correspond to the symbols V_{BBM1}, V_{BBM2}, V_{BBM3} and V_{BBM4} in Fig. 8 in accordance with the roles thereof.

Sectional views of embodiments of chips which are obtained for the embodiment of the chip setup in Figs. 7 and 8 will be elucidated below. Each of them illustrates the sectional structure of the portions of the input circuit and dynamic memory cell of a MOS dynamic RAM in correspondence with the prior-art example in Fig. 1. Although the memory cell is the dynamic cell here, the present invention is similarly applicable to a MOS static memory cell and a bipolar static memory cell.

In an embodiment in Fig. 9, the nMOS transistors of an input protection circuit (an n-type diffused resistor and an nMOS diode) and an input circuit are formed in a p-well (pW), the pMOS transistor of the input circuit is formed in an n-well (nW), and a memory cell made of an nMOS transistor is formed in a p-type substrate p-Sub. In the present embodiment, the p-well of the input circuit and the substrate p-Sub are isolated. Therefore, the values of the isolation voltages V_{BBM2} and V_{BBM4} of the respective regions can be independently set. Accordingly, by way of example, the voltage V_{BBM2} can be selected at -3 V in order to satisfy the specifications of the input circuit, and the voltage V_{BBM4} can be selected at 0 V from the viewpoint of the soft-error immunity of the memory cell. A broken line under the memory cell indicates a p-type high impurity concentration layer. In this way, the disadvantage of the prior-art example elucidated in Fig. 1 can be prevented to provide a stable dynamic memory.

In Fig. 10, only the n-type diffused resistor and nMOS diode of an input protection circuit are provided in a p-well, and the nMOS transistors of any other peripheral circuits are formed in a p-type substrate p-Sub likewise to a memory cell. Besides, a pMOS transistor can be formed in an n-well. A voltage V_{BBM2} (for example, -3 V) is applied to the p-well under the n-type diffused resistor and nMOS diode which are input protection devices, while a voltage V_{BBM4} (for example, 0 V) is applied to the substrate p-Sub of the nMOS transistors of the input circuit and the memory cell. A p-type high concentration layer is provided under the memory cell as in Fig. 9. A voltage V_{BBM1} is applied to the n-well. The present embodiment is advantageous over the embodiment of Fig. 9 in that, since only the input protection devices are provided in the well, the layout is simplified, and that, since the nMOS transistors other than the input protection diode are formed under the same concentration condition over the cell and the peripheral circuit, the control of threshold voltages V_{TH} is easy.

Fig. 11 illustrates an embodiment in which a memory cell is formed in a p-well (pW), while the nMOS transistors of an input protection circuit and any other peripheral circuit are formed in a p-type substrate p-Sub. In the present embodiment, the p-well of comparatively high concentration is provided under the memory cell, and it acts as the substitute of the high concentration layer indicated by the broken line in Fig. 9 or 10.

In the above embodiments are applied to the MOS memories (SRAM, DRAM). Next, embodiments in each of which the present invention is applied to a memory by the use of the BiCMOS construction of Fig. 5 having both bipolar and MOS devices will be described with reference to Figs. 12 - 16. Among the embodiments, those of Figs. 12 - 14 employ epitaxial layers, and those of Figs. 15 - 17 don't employ epitaxial layers.

Fig. 12 shows the nMOS, pMOS and n-p-n bipolar transistors of peripheral circuits, and a dynamic type nMOS memory cell as viewed from the left.

Under the nMOS memory cell, a p-type buried layer (pBL) of high impurity concentration is put to intensify the soft-error immunity. This layer pBL is also used for the isolation of an n-type buried layer.

Although the nMOS transistor of the peripheral circuit is formed in a p-well, this p-well can be omitted when a p-type epitaxial layer is employed. An n-type buried layer nBL of high concentration is provided under this p-well layer, and an n-layer (CN) of high concentration is added for feeding a voltage to the layer nBL. Besides, the p-well has its side surrounded with an n-well thereby to be isolated from a p-type substrate p-Sub. A voltage V_{BBM2} (for example, -3 V) is applied to the nMOS transistor of the peripheral circuit, and the voltage V_{BBM1} (for example, a supply voltage V_{CC}) to the n-well of the pMOS transistor. A common voltage V_{BBM4} is applied to the isolation layer of the n-p-n bipolar transistor and that of the nMOS transistor of the memory cell. Buried layers nBL and pBL provided under a well serve to reduce the collector resistance of the bipolar transistor, and are also effective to'prevent latch-up through the decrease of a substrate resistance.

Fig. 13 illustrates an embodiment in which a memory cell is formed in a p-type substrate p-Sub, and the difference of which from the embodiment of Fig. 12 consists only in a construction under the memory cell. With the construction in Fig. 12, the buried layer pBL of high concentration might rise and cause the threshold voltage V_{TH} of the nMOS transistor to fluctuate. In contrast, according to the construction in Fig. 13, a p-type high concentration layer indicated by a broken line is provided only under a storage capacitor so as to prevent the buried layer from rising to the channel part of the nMOS transistor of the memory cell.

Next, principal steps for realizing the sectional structure of Fig. 13 are illustrated in Fig. 14. At (a) in Fig. 14, n-type buried layers nBL are formed in the front surface of a p-type substrate, and at (b), a p-type buried layer pBL is further formed. Thereafter, a layer Epi is formed by epitaxial growth at (c), and n-wells (nWELL) and p-wells (pWELL) are formed in the layer Epi by steps (d) and (e). At (f), layers CN heavily doped with an n-type impurity are formed so as to connect with the underlying layers nBL. Though not shown in the drawing, the plate of a memory cell, the gates of MOS transistors, the source and drain layers of the MOS transistors, and if necessary, the emitter layer of a bipolar transistor are thereafter formed. Further, steps such as the formation of contact holes and metalization are thereafter required. In the illustration of Figs. 17 and 18, the layers CN and nBL reduce the collector resistance of the bipolar transistor. On the other hand, the contact interfaces between the sources and drains and the wells of the MOS transistors and between the base and the collector of the bipolar transistor do not establish the contacts between layers of very high concentrations, and they can have their breakdown voltages held at degrees necessary for circuit operations.

The above has been the example of the process employing the epitaxial layer, and embodiments which do not employ the epitaxial layer will now be described with reference to Figs. 15 - 17. These embodiments form a high concentration layer in the place of a p-type substrate at a fixed depth by the use of implantation. For this reason, they can curtail the cost of manufacture as compared with the case of employing the epitaxial layer.

Fig. 15 is a sectional view, and the corresponding conceptual diagram seen from the front surface of a chip is shown in Fig. 16. An nMOS transistor nMOS1 has its p-type isolation layer (pWELL) enclosed with an n-layer (CN or n-well), thereby to be isolated from a p-type substrate p-Sub.

The principal steps of a process for realizing the structure of Figs. 15 and 16 are shown in Fig. 17. At (a), an n-layer of high concentration is provided in a substrate p-Sub at a fixed depth from the front surface thereof by ion implantation. Thereafter, an n-well and a p-well are formed at (b) and (c). The p-well can be omitted in the case of the p-type substrate p-Sub. At (d), n-layers (CN) of high concentration are formed so as to reach the n-type buried layer nBL. Steps after (d), for forming MOS and bipolar devices and metalization are similar to conventional steps.

As described above in conjunction with many embodiments, according to the present invention, independent voltages as desired can be applied to the substrate and isolation layer of a MOS device and the isolation layer of a bipolar device, and the optimum voltages conforming to the purposes of the circuits of the devices can be selected. Thus, the setting of concentration profiles, the setting of isolation voltages, etc. can be freely done in order to cope with the problems of the undershoots of inputs and outputs, junction capacitances, and soft errors.

### Industrial Applicability:

Heretofore, the injection of minority carriers ascribable to surge noise etc. has arisen at a p-n junction constituting a MOS transistor or a BiP transistor formed in a silicon substrate, and it has formed the cause of such a problem as the destruction of a stored signal in an SRAM or a DRAM.

Such a phenomenon degrades the reliability of the semiconductor device and is unfavorable.

The present invention can prevent the phenomenon, is applicable to various products including MOS, BiP, CMOS, Bi-MOS and Bi-CMOS devices and is capable of enhancements in the reliability etc., so that it can be effectively utilized.

## Claims

1. A semiconductor device formed within a first region of a substrate (p-Sub) of a first conductivity type (p) comprising
a first well layer (nW) of the second conductivity type (n) formed within said first region, a second well layer (pW1, pW2) of the first conductivity type (p) formed within said first well layer (nW),
a first insulated-gate field effect transistor (nMOS3) of a first channel type having source and drain of said second conductivity type (n) formed in said first region at its surface and a second insulated-gate field effect transistor (nMOS1, nMOS2) of the first channel type having source and drain of said second conductivity type (n) formed in said second well layer (pW1, pW2) at its surface,
first voltage means to apply a first voltage (VBB4) to said first well layer (nW), second voltage means to apply and a second voltage (VBB2, VBB3) to said second well layer (pW1, pW2) and third voltage means to apply a third voltage (VBB1) to said first region,
wherein the first voltage (VBB4) isolates the second well layer (pW1, pW2) and the first region,
and wherein the value of said second voltage (VBB2, VBB3) is different from that of said third voltage (VBB1).

2. The semiconductor device according to claim 1, wherein a third insulated-gate field effect transistor (pMOS1, pMOS2) of the second channel type having source and drain of said first conductivity type (p) is formed in said first well layer (nW1, nW2) at its surface.

3. The semiconductor device according to claim 1 or 2, wherein a third well layer (nW3) of the second conductivity type (n) is formed within said first region,
a fourth insulated-gate field effect transistor (pMOS3) of the second channel type having source and drain of said first conductivity type (p) is formed in said third well layer (nW3) at its surface and
the value of a fourth voltage (VBB6) applied to said third well layer (nW3) is different from that of said first voltage.

4. A semiconductor device formed within a first region of a substrate (p-Sub) of a first conductivity type (p) comprising
a first well layer (nW) of the second conductivity type (n) formed within said first region, a second well layer (pW1, pW2) of the first conductivity type (p) formed within said first well layer (nW),
a first bipolar transistor npn3) having a first emitter and a first collector of said second conductivity type (n) and a first base of said first conductivity type (p), a second bipolar transistor (npn1, npn2) having a second emitter and a second collector of said second conductivity type (n) and a second base of said first conductivity type (p), wherein said first bipolar transistor (npn3) is formed in said first region at its surface and said second bipolar transistor (npn1, npn2) is formed in said second well layer (pW1, pW2) at its surface, wherein said first base is disposed in said first collector and wherein said first emitter is disposed in said first base, wherein said second base is disposed in said second collector and wherein said second emitter is disposed in said second base,
first voltage means to apply a first voltage (VBB4) to said first well layer (nW), second voltage means to apply a second voltage (VBB2, VBB3) to said second well layer (pW1, pW2) and third voltage means to apply a third voltage (VBB1) to said first region,
wherein the first voltage (VBB4) isolates the second well layer (pW1, pW2) and said first region,
and wherein the value of said second voltage (VBB2, VBB3) is different from that of said third voltage (VBB1).

5. The semiconductor device according to claim 4, wherein a third bipolar transistor (pnp1) of the second type (pnp) having emitter and collector of said first conductivity type (p) and a base of said second conductivity type (n) is formed in the first well layer (nW) at its surface.

6. The semiconductor device according to any of claims 1 to 5, wherein said first conductivity type is p-type and said second conductivity type is n-type.

## Patentansprüche

1. Halbleiterbauelement, das in einem ersten Bereich eines Substrat (p-Sub) eines ersten Leitungstyps (p) ausgebildet ist, mit
einer ersten Wannenschicht (nW) des zweiten Leitungstyps (n), die in dem ersten Bereich ausgebildet ist, einer zweiten Wannenschicht (pW1, pW2) des ersten Leitungstyps (p), die in der ersten Wannenschicht (nW) ausgebildet ist,
einem ersten Feldeffekttransistor mit einem isolierten Gate (nMOS3) eines ersten Kanal-Typs mit einer Source und einem Drain des zweiten Leitungstyps (n), der im ersten Bereich an dessen Oberfläche ausgebildet ist, und einem zweiten Feldeffekttransistor mit einem isolierten Gate (nMOS1, nMOS2) des ersten Kanal-Typs mit einer Source und einem Drain des zweiten Leitungstyps (n), der in der zweiten Wannenschicht (pW1, pW2) an deren Oberfläche ausgebildet ist,
einer ersten Spannungseinrichtung zum Anlegen einer ersten Spannung (VBB4) an die erste Wannenschicht (nW), einer zweiten Spannungseinrichtung zum Anlegen einer zweiten Spannung (VBB2, VBB3) an die zweite Wannenschicht (pW1, pW2) und einer dritten Spannungseinrichtung zum Anlegen einer dritten Spannung (VBB1) an den ersten Bereich,
wobei die erste Spannung (VBB4) die zweite Wannenschicht (pW1, pW2) und den ersten Bereich isoliert, und
wobei der Wert der zweiten Spannung (VBB2, VBB3) von dem der dritten Spannung (VBB1) verschieden ist.

2. Halbleiterbauelement gemäß Anspruch 1, wobei ein dritter Feldeffekttransistor mit einem isolierten Gate (pMOS1, pMOS2) des zweiten Kanal-Typs mit einer Source und einem Drain des ersten Leitungstyps (p) in der ersten Wannenschicht (nW1, nW2) an deren Oberfläche ausgebildet ist.

3. Halbleiterbauelement gemäß einem der Ansprüche 1 oder 2, wobei eine dritte Wannenschicht (nW3) des zweiten Leitungstyps (n) im ersten Bereich ausgebildet ist,
ein vierter Feldeffekttransistor mit einem isolierten Gate (pMOS3) des zweiten Kanal-Typs mit einer Source und einem Drain des ersten Leitungstyps (p) in der dritten Wannenschicht (nW3) an deren Oberfläche ausgebildet ist, und
der Wert einer an die dritte Wannenschicht (nW3) angelegten vierten Spannung (VBB6) von dem der ersten Spannung verschieden ist.

4. Halbleiterbauelement, das in einem ersten Bereich eines Substrats (p-Sub) eines ersten Leitungstyps (p) ausgebildet ist, mit
einer ersten Wannenschicht (nW) des zweiten Leitungstyps (n), die in dem ersten Bereich ausgebildet ist, einer zweiten Wannenschicht (pW1, pW2) des ersten Leitungstyps (p), die in der ersten Wannenschicht (nW) ausgebildet ist,
einen ersten Bipolar-Transistor (npn3) mit einem ersten Emitter und einem ersten Kollektor des zweiten Leitungstyps (n) und einer ersten Basis des ersten Leitungstyps (p), einem zweiten Bipolar-Transistor (npn1, npn2) mit einem zweiten Emitter und einem zweiten Kollektor des zweiten Leitungstyps (n) und einer zweiten Basis des ersten Leitungstyps (p), wobei der erste Bipolar-Transistor (npn3) in dem ersten Bereich an dessen Oberfläche ausgebildet ist und der zweite Bipolar-Transistor (npn1, npn2) in der zweiten Wannenschicht (pW1, pW2) an deren Oberfläche ausgebildet ist, wobei die erste Basis in dem ersten Kollektor, und wobei der erste Emitter in der ersten Basis angeordnet sind, wobei die zweite Basis in dem zweiten Kollektor und wobei der zweite Emitter in der zweiten Basis angeordnet sind,
einer ersten Spannungseinrichtung zum Anlegen einer ersten Spannung (VBB4) an die erste Wannenschicht (nW), einer zweiten Spannungseinrichtung zum Anlegen einer zweiten Spannung (VBB2, VBB3) an die zweite Wannenschicht (pW1, pW2) und einer dritten Spannungseinrichtung zum Anlegen einer dritten Spannung (VBB1) an den ersten Bereich,
wobei die erste Spannung (VBB4) die zweite Wannenschicht (pW1, pW2) und den ersten Bereich isoliert,
und wobei der Wert der zweiten Spannung (VBB2, VBB3) von dem der dritten Spannung (VBB1) verschieden ist.

5. Halbleiterbauelement gemäß Anspruch 4, wobei ein dritter Bipolar-Transistor (pnp1) des zweiten Typs (pnp) mit einem Emitter und einem Kollektor des ersten Leitungstyps (p) und einer Basis des zweiten Leitungstyps (n) in der ersten Wannenschicht (nW) an deren Oberfläche ausgebildet ist.

6. Halbleiterbauelement gemäß einem der Ansprüche 1 bis 5, wobei der erste Leitungstyp der p-Typ und der zweite Leitungstyp der n-Typ ist.

## Revendications

1. Dispositif à semiconducteurs formé dans une première région d'un substrat (p-Sub) d'un premier type (p) de conductivité, comprenant:
une première couche formant puits (nW) du second type (n) de conductivité formée dans ladite première région, une seconde couche formant puits (pW1, pW2) du premier type (p) de conductivité formée dans ladite première couche formant puits (nW).
un premier transistor (nMOS3) à effet de champ à grille isolée à canal d'un premier type ayant une source et un drain dudit second type (n) de conductivité formé dans ladite première région sur sa surface, et un second transistor (nMOS1, nMOS2) à effet de champ à grille isolée à canal du premier type ayant une source et un drain dudit second type (n) de conductivité formé dans ladite seconde couche formant puits (pW1, pW2) sur sa surface,
un premier moyen d'application de tension pour appliquer une première tension (VBB4) à ladite première couche formant puits (nW), un second moyen d'application de tension pour appliquer une seconde tension (VBB2, VBB3) à ladite seconde couche formant puits (pW1, pW2) et un troisième moyen d'application de tension pour appliquer une troisième tension (VBB1) à ladite première région,
la première tension (VBB4) étant isolée de la seconde couche formant puits (pW1, pW2) et de la première région,
et la valeur de ladite seconde tension (VBB2, VBB3) étant différente de celle de ladite troisième tension (VBB1).

2. Dispositif à semiconducteurs selon la revendication 1, dans lequel un troisième transistor (pMOS1, pMOS2) à effet de champ à grille isolée à canal du second type ayant une source et un drain dudit premier type (p) de conductivité est formé dans ladite première couche (nW1, nW2) sur sa surface.

3. Dispositif à semiconducteurs selon la revendication 1 ou 2, dans lequel une troisième couche formant puits (nW3) du second type (n) de conductivité est formée dans ladite première région,
un quatrième transistor (pMOS3) à effet de champ à grille isolée à canal du second type ayant une source et un drain dudit premier type de conductivité (p) est formé dans ladite troisième couche formant caisson (nW3) sur sa surface, et
la valeur d'une quatrième tension (VBB6) appliquée à ladite troisième couche formant caisson (nW3) est différente de celle de ladite première tension.

4. Dispositif à semiconducteurs formé dans une première région d'un substrat (p-Sub) d'un premier type (p) de conductivité, comprenant
une première couche formant puits (nW) du second type (n) de conductivité formée dans ladite première région, une seconde couche formant puits (pW1, pW2) du premier type (p) de conductivité formée dans ladite première couche formant puits (nW),
un premier transistor bipolaire (npn3) ayant un premier émetteur et un premier collecteur dudit second type (n) de conductivité et une première base dudit premier type (p) de conductivité, un second transistor bipolaire (npn1, npn2) ayant un second émetteur et un second collecteur dudit second type (n) de conductivité et une seconde base dudit premier type (p) de conductivité, ledit premier transistor bipolaire (npn3) étant formé dans ladite première région sur sa surface et ledit second transistor bipolaire (npnl, npn2) étant formé dans ladite seconde couche formant puits (pW1, pW2) sur sa surface, ladite première base étant disposée dans ledit premier collecteur et ledit premier émetteur étant disposé dans ladite première base, ladite seconde base étant disposée dans ledit second collecteur et ledit second émetteur étant disposé dans ladite seconde base,
un premier moyen d'application de tension pour appliquer une première tension (VBB4) à ladite première couche formant puits (nW), un second moyen d'application de tension pour appliquer une seconde tension (VBB2, VBB3) à ladite seconde couche formant puits (pW1, pW2) et un troisième moyen d'application de tension pour appliquer une troisième tension (VBB1) à ladite première région,
la première tension (VBB4) étant isolée de la seconde couche formant puits (pW1, pW2) et de ladite première région,
et la valeur de ladite seconde tension (VBB2, VBB3) étant différente de celle de ladite troisième tension (VBB1).

5. Dispositif à semiconducteurs selon la revendication 4, dans lequel un troisième transistor bipolaire (pnp1) du second type (pnp) ayant un émetteur et un collecteur dudit premier type (p) de conductivité et une base dudit second type (n) de conductivité est formé dans la première couche formant caisson (nW) sur sa surface.

6. Dispositif à semiconducteurs selon l'une quelconque des revendications 1 à 5, dans lequel ledit premier type de conductivité est le type p et ledit second type de conductivité est le type n.
